# EUROPEAN PATENT SPECIFICATION

(11) **EP 4 042 172 B1**
(45) Date of publication and mention of the grant of the patent: **17.07.2024**
(21) Application number: 20828988.4
(22) Date of filing: 15.12.2020
(51) Int. Cl.: G01R 31/28, G01R 31/27, G01R 31/3185

(54) **METHODS AND SYSTEMS FOR ASSESSING PRINTED CIRCUIT BOARDS**
VERFAHREN UND SYSTEME ZUR BEURTEILUNG VON LEITERPLATTEN
PROCÉDÉS ET SYSTÈMES POUR ÉVALUER DES CARTES DE CIRCUIT IMPRIMÉ

(30) Priority: 20.12.2019 EP 19218526
(43) Date of publication of application: 17.08.2022
(73) Proprietor: Siemens Aktiengesellschaft, 80333 München (DE)
(72) Inventor: BÖNIG, Jochen, 90408 Nürnberg (DE); KARLSHÖFER, Hans, 86919 Utting am Ammersee (DE); KRAJEWSKI, Grzegorz, 99-100 Leczyca (PL); KRAUS, Stefan, 96155 Buttenheim (DE); KROMPASS, Markus, 70563 Stuttgart (DE); MAGG, Michael, 91058 Erlangen (DE); MICHEL, Martin, 82110 Germering (DE); MOODY, Robert, Knutsford Cheshire WA168DE (GB); SANDMANN, Michaela, 91353 Hausen (DE); SCHWULERA, Erik, 91058 Erlangen (DE); WEIGAND, Kerstin, 91330 Eggolsheim (DE)
(74) Representative: Siemens Patent Attorneys
(86) International application number: PCT/EP2020/086229
(87) International publication number: WO 2021/122604

(56) References cited:
- US-B1- 6 738 450
- US-B2- 7 133 797
- SHAJI KRISHNAN ET AL: "A Robust Metric for Screening Outliers from Analogue Product Manufacturing Tests Responses", EUROPEAN TEST SYMPOSIUM (ETS), 2011 16TH IEEE, IEEE, 23 May 2011 (2011-05-23), pages 159 - 164, XP031897578, ISBN: 978-1-4577-0483-3, DOI: 10.1109/ETS.2011.31

## Description

The invention relates to a computer-implemented method for assessing at least one printed circuit board, where an assignment of the at least one printed circuit board to one of at least two different classes is provided with aid of a trained classification function.

Furthermore, the invention relates to a computer program comprising instructions which, when the program is executed by a system, cause the system to carry out the above-mentioned computer-implemented method.

Moreover, the invention relates to a system for assessing at least one printed circuit board.

Furthermore, a computer-implemented method for providing a trained classification function, which can be utilized in the above-mentioned method for assessing printed circuit boards is disclosed.

Moreover, a computer-implemented method for providing a trained recommendation function for printed circuit board testing, which can be utilized in the above-mentioned method for assessing printed circuit boards is disclosed.

Moreover, a machine-readable data medium comprising at least one such assignment is disclosed.

Within the area of the manufacturing of electronical devices there is a fairly high process maturity regarding the manufacturing and assembly of printed circuit boards (PCB). Methods and systems for PCB testing are known in the prior art. For example, the US patent US 6 738 450 B1 shows methods and systems for examining solder joints of the PCB based on image processing. US 7 133 797 B2 relates to a function test for PCBs based on a predefined behavior of input / output signals.

However, there is still to verify that the right component is at the right place and electrically correct connected to the board without shortcuts or open connections. Therefore, an electrical test is necessary. An example of such test is a test, where the electrical value of each components is measured separately by contacting the components directly or via test pads. Due to bad connections e.g., contamination of the pads or needles the resulting measurements deviates from the expected range of the component value so that a good product is judged as a defect (pseudo error). I.e. the term "bad [electrical] connection" is an opposite to a term "ideal connection", which means that the connection itself has zero resistance and zero capacity. In case of a bad electrical connection due to contamination (of needles), dirt (in joints), temperature (of PCBs) etc. the connection itself has a non-zero capacity and/or a non-zero resistance. Therefore, the bad electrical connection may lead to false measured values of the electrical parameters of the electronic components of the PCB, e.g. false values of the resistances and/or capacitances, and to the pseudo errors. The pseudo-errors may lead to a retesting or additional effort for quality inspections and thus reduces the overall capacity and effectiveness of the production equipment. The occurrence of pseudo errors tends to be randomly or with different and changing root causes, so that the process optimizations are either costly or not sustainable and the re-testing is an accepted situation.

Accordingly, there is a need to provide for methods and systems that can cope with huge amount of data that arise during the printed circuit boards testing and more reliable than currently existing methods and systems.

In order to achieve the objective mentioned above, the present invention provides a computer-implemented method for assessing at least one printed circuit board, which method comprises:
- receiving input data, wherein the input data is based on a testing data of at least one, more particularly, of a plurality of printed circuit board(s), wherein the testing data is an in-circuit test testing data and comprises measurement data of a plurality of electronic components of the at least one printed circuit board;
- applying a trained classification function to the input data, wherein an output data is generated;
- providing the output data, wherein the output data comprises an assignment of at least one of the plurality, preferably of each of the plurality of the electronic components of the at least one printed circuit board to one of at least two different classes.

In an embodiment the output data comprises a plurality of assignments, wherein each assignment is an assignment of at least one of the plurality of the electronic components of the at least one printed circuit board and different assignments relate to different electronic components.

The assessment of the at least one printed circuit board is performed based on the output data, i.e. on the assignment of at least one of the plurality of the electronic components of the at least one printed circuit board. Particularly, the output data comprises a plurality of assignments, wherein each assignment relates to a particular electronic component and different electronic components have different assignments.

Using the trained classification function allows for higher precision when it comes to assigning a particular feature to the tested printed circuit board(s).

In an embodiment the output data can be realized as input data augmented by the corresponding assignment(s), i.e. labelled or categorized input data.

In some embodiments, the trained classification function can be based on a multi-variate classification algorithm, more particular, the multi-variate classification algorithm can be an ordinary linear regression algorithm, a random forest algorithm, a gradient boosting algorithm, a LASSO algorithm, in particular, an adaptive LASSO algorithm, more particularly a linear regression algorithm with regularization, or a logistic regression algorithm, in particular, a binary logistic regression algorithm.

In some embodiments, one of the at least two classes corresponds to a category of pseudo-malfunctioning printed circuit boards. The pseudo-malfunctioning printed circuit boards are printed circuit boards with a pseudo-error. I.e. at least one of the plurality of the electronic components of the at least one printed circuit board has a pseudo-error ("false bad"). The pseudo-malfunctioning printed circuit boards are functioning printed circuit boards that failed the test due to one or another external conditions, e.g. temperature of the printed circuit boards, contamination of the pads etc. Use of the trained classification function allows to increase the precision of the detection of the pseudo-erroneous printed circuit boards.

In other words, the trained classification function can be adapted or trained to detect pseudo-erroneous electronic components. How a classification function can be trained, e.g. based on historical ICT measurement data and the corresponding historical assignment data, e.g. human expert's assignment data, is discussed further below. The trained classification function is able to subtract the "noise" from the measurement data, which is introduced during the ICT measurements by one or more above-mentioned effects, for example by contaminated needles, "hot" printed circuit boards etc.

In some embodiments, the at least one, more particularly each printed circuit board is assigned to the group of three classes, more particular, to the group consisting of:
a first class ("PASS"), wherein the first class corresponds to a category of functioning printed circuit boards;
a second class ("FAIL"), wherein the second class corresponds to a category of malfunctioning printed circuit boards, and
a third class ("PSEUDO-ERROR"), wherein the third class corresponds to the category of pseudo-malfunctioning printed circuit boards.

Retesting in case of ICT is costly, so that detecting pseudo-errors in this case dramatically reduces the production costs.

In some embodiments the measurement data of the plurality of the electronic components of the at least one printed circuit board comprises measurement data of at least one electrical parameter of each electronic component of the plurality of the electronic components of the at least one printed circuit board. The electrical parameters can be analog and/or digital parameters. For instance, the testing can comprise measurements of resistances, inductivities, etc. I.e. the measurement data may comprise (different) electrical parameters of single electronic elements of the at least one printed circuit board. As explained above, a measurement of a single electronic component (e.g. a resistance) may produce non-zero values for different electrical parameters (resistance, inductivity) e.g. due to the bad connections.

In an embodiment the input data and the output data can comprise layout information of the at least one printed circuit board and the providing the output data comprises visualizing the measurement data of the at least one parameter of each electronic component of the plurality of the electronic components of the at least one printed circuit board, wherein the visualization is based on / performed with aid of the layout information.

In some embodiments plurality of the printed circuit boards of different types can be tested and the input data and the output data can comprise layout information of at least one type of the printed circuit boards. In an embodiment the input data and the output data can comprise layout information of each type of the printed circuit boards.

In some embodiments the method can comprise optimizing at least one of statistical parameters, wherein the statistical parameters determine a pre-specified allowed range of values of the at least one electrical parameter of each electronic component of the plurality of the electronic components of the at least one printed circuit board and providing the output data can comprise recommending the at least one optimized statistical parameter for use in the further testing.

In some embodiments the optimizing can be performed based on recently achieved testing data, i.e. recent historical data. The recent historical data can be for example the data collected during the current production cycle or/and the data collected in the last two, three or four weeks. In this way the allowed range of values can be adjusted to the lab conditions of the testing.

The statistical parameter(s) can be a location parameter, e.g. a mean value, and/or of a spread parameter e.g. standard deviation, variance, range, interquartile range, absolute deviation or any other. These parameters can characterize (are measures of) statistical dispersion.

For example, a mean value of a certain capacity can be evaluated over some period of time. E.g. a mean value of the measured values of this capacity over the last 4 weeks can be evaluated and based on this an adjusted confidence interval can be suggested.

The recommending can be performed during the visualization step, e.g. the testing data augmented by the assignment or assignments can be visualized, such that the allowed values and recommended values are represented, e.g. on a screen or on an HMI.

In some embodiments the recommending can be performed by means of a trained recommendation function, more particularly, the trained recommendation function is based on a data-driven optimization, particularly on a distributionally robust optimization and/or an online linear programming algorithm and/or a least squares with nonconvex regularization and/or an alternating direction method of multipliers with multiple blocks. In this way, a fully automated testing data assessment process can be achieved.

Also disclosed a machine-readable data medium comprising the above-mentioned assignment(s) is provided.

According to one aspect of the invention a computer-implemented method for providing a trained classification function is provided. The trained classification function can be utilized in the above-mentioned method for assessing printed circuit boards. The training method comprises:
A0) receiving training input data and training output data, wherein the training input data is representative of an in-circuit test testing data, wherein the ICT testing data comprises (historical) measurement data of a plurality of electronic components of the at least one printed circuit board and the training output data is representative of assignments (historical assignment data) of at least one of the plurality of the electronic components of the printed circuit boards, wherein each assignment is an assignment of the at least one of the plurality of the electronic components to one of at least two different classes;
B0) executing a classification function on the training input data in order to generate predicted training output data;
C0) comparing the training output data to the predicted training output data in order to determine an error;
D0) updating the classification function in accordance with the determined error, and
E0) performing the steps A0) to D0) in an iterative manner to reduce the error.

Different assignements correspond to different electronic components.

The training input and output data comprise historical data, i.e. data, which is available from previous ICT measurements (training measurement data) and the corresponding assignments of the electronic components of the printed circuit boards (training assignment data).

Training input data and training output data form the so-called training dataset. The training dataset can be a part of the entire testing data.

In some embodiments the training dataset can comprise about or less than 20% of the entire testing data. In this way the probability of overfitting of the classification function can be reduced.

In some embodiments the training dataset in every iteration of steps A0 to D0 can be chosen not to overlap or to only partially overlap the previously chosen training data sets from the entire training data.

In some embodiments the training input data and the training output data can be pre-processed before the classification function is executed.

In some embodiments the method can comprise cross-validating.

In some embodiments the classification function can be based on a multi-variate classification algorithm, more particular, the multi-variate classification algorithm is an ordinary linear regression algorithm, a random forest algorithm, a gradient boosting algorithm, a LASSO algorithm, in particular, an adaptive LASSO algorithm, more particularly a linear regression algorithm with regularization, or a logistic regression algorithm, in particular, a binary logistic regression algorithm.

In an embodiment the one of the at least two classes corresponds to a pseudo-malfunctioning category.

In some embodiments, the at least one printed circuit board can be assigned to the group of three classes, more particular, to the group consisting of:
a first class, wherein the first class corresponds to a functioning category of printed circuit boards;
a second class, wherein the second class corresponds to malfunctioning category of printed circuit boards, and
a third class, wherein the third class corresponds to the pseudo-malfunctioning category of printed circuit boards. The feature vector has three entries in this case corresponding to "PASS", "FAIL" and "PSEUDO-ERROR" category accordingly.

According to one aspect of the invention a computer-implemented method for providing a trained recommendation function for printed circuit board testing is provided, wherein the method comprises:
A1) receiving training input data and training output data, wherein the training input data is representative of recommendations of at least one optimized statistical parameter, wherein (not yet optimized) statistical parameters determine a pre-specified range of values of at least one electrical parameter of each electronic component of a plurality of electronic components of the at least one printed circuit board, wherein the pre-specified range of values comprise values that are allowed during printed circuit board testing and the training output data is representative of acceptance of the recommendations;
B1) executing a recommendation function on the training input data in order to generate predicted training output data;
C1) comparing the training output data to the predicted training output data in order to determine an error;
D1) updating the recommendation function in accordance with the determined error, and
E1) performing the steps A1) to D1) in an iterative manner to reduce the error.

The (not yet optimized) statistical parameters can be provided by a human expert.

The (not yet optimized) statistical parameters do not depend on and/or allow for the conditions of the current testing procedure.

In some embodiments the recommendation function can be based on a data-driven optimization, particularly on a distributionally robust optimization and/or an online linear programming algorithm and/or a least squares with nonconvex regularization and/or an alternating direction method of multipliers (ADMM) with multiple blocks.

According to one aspect of the invention a computer program is provided, wherein the computer program comprises instructions which, when the program is executed by a system, cause the system to carry out the above-described computer-implemented methods.

According to one aspect of the invention a system is provided comprising
- a first interface, configured for receiving input data, wherein the input data is based on a testing data of at least one printed circuit board, wherein the testing data is an in-circuit test testing data and comprises measurement data of a plurality of electronic components of the at least one printed circuit board;
- a computation apparatus, configured for applying a trained classification function to the input data to generate an output data;
- a second interface, configured for providing the output data, wherein the output data comprises an assignment of at least one of the plurality of the electronic components of the at least one printed circuit board to one of at least two different classes.

In some embodiments the computation apparatus or the second interface can be configured for
- optimizing at least one of statistical parameters, wherein the statistical parameters determine a pre-specified range of allowed values of at least one electrical parameter of each electronic component of the plurality of the electronic components of the at least one printed circuit board, wherein
the computation apparatus or the second interface is configured for
- recommending, more particularly by applying a trained recommendation function, the at least one optimized statistical parameter for use in the further testing, while providing the output data.

According to one aspect of the invention a training system for providing a trained classification function is provided, wherein the training system comprises a first training interface, configured for receiving training input data and training output data, wherein the training input data is representative of an in-circuit test testing data, wherein the ICT testing data comprises measurement data of a plurality of electronic components of the at least one printed circuit board and the training output data is representative of assignments of at least one of the plurality of the electronic components, wherein each assignment is an assignment of a printed circuit board to one of at least two different classes; a training computation apparatus, configured for
* executing a classification function on the training input data in order to generate predicted training output data;
* comparing the training output data to the predicted training output data in order to determine an error;
* updating the classification function in accordance with the determined error, and a second training interface, configured for providing the trained classification function.

According to one aspect of the invention a training system for providing a trained recommendation function for printed circuit board testing is provided, wherein the training system comprises
- a first training interface, configured for receiving training input data and training output data, wherein the training input data is representative of recommendations of at least one optimized statistical parameter, wherein statistical parameters determine a pre-specified range of values of at least one electrical parameter of each electronic component of a plurality of electronic components of the at least one printed circuit board, wherein the pre-specified range of values comprise values that are allowed during printed circuit board testing and the training output data is representative of acceptance of the recommendations;
- a training computation apparatus, configured for
   * executing a recommendation function on the training input data in order to generate predicted training output data;
   * comparing the training output data to the predicted training output data in order to determine an error;
   * updating the recommendation function in accordance with the determined error, and
- a second training interface, configured for providing the trained recommendation function.

The above and other objects and advantages of the invention will be apparent upon consideration of the following detailed description, taken in conjunction with the accompanying drawings, in which like reference characters refer to like parts throughout, and in which:
- FIG 1: is an example of an environment, in which testing data of a plurality of printed circuit boards can be assessed;
- FIG 2: is a flow diagram of an example of a computer-implemented method for assessing at least one printed circuit board;
- FIG 3: is an example of the visualization of PCB layout information;
- FIG 4: is a flow diagram of an example of a computer-implemented method for assessing at least one printed circuit board and for visualizing the results;
- FIG 5: is an example of an environment, in which testing data of a plurality of printed circuit boards can be assessed, visualized and optimized parameters for testing can be suggested;
- FIG 6 and FIG 7: are flow diagrams of methods for producing a machine-readable medium;
- FIG 8: is an example of a computer-implemented method for providing a trained classification function;
- FIG 9: is an example of data-preprocessing;
- FIG 10: is an example of a computer-implemented method for providing the trained recommendation function, and
- FIG 11: is an example of a training system for providing trained functions, e.g. a trained classification function or/and a trained recommendation function.

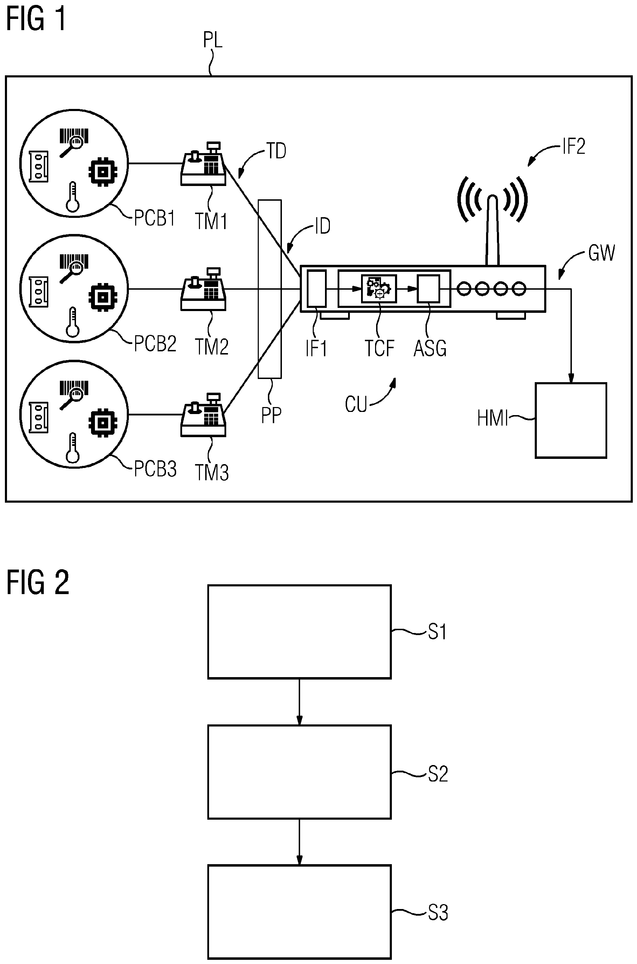

Turning to FIG 1 and FIG 2, an example of an environment, in which testing data of several printed circuit boards PCB1, PCB2, PCB3 can be assessed and an example of a computer-implemented method, which can be implemented in such environment, are displayed.

In particular, FIG 1 shows an industrial plant PL or a factory, in which printed circuit boards are manufactured. It will be appreciated by a person skilled in the art that the number of printed circuit boards PCB1, PCB2, PCB3 can be more than 3, although only three of them are shown. Usually, there are hundreds or sometimes thousands of the printed circuit boards in a printed circuit board manufacturing facility PL. Each printed circuit board PCB1, PCB2, PCB3 undergoes a quality testing procedure before it leaves the factory PL. During this testing a testing data is generated. A test performed on the printed circuit boards PCB1, PCB2, PCB3 is an in-circuit test (ICT). Therefore, the testing data of the printed circuit boards PCB1, PCB2, PCB3 is an ICT measurements data. During the ICT measurement data of a plurality of electronic components, particularly of each electronic component of each circuit board PCB1, PCB2, PCB3 is achieved. For example one or more electrical parameters of each of the plurality of the electronic components is (are) measured during the ICT measurement.

The in-circuit tests of each printed circuit board PCB1, PCB2, PCB3 can be performed by one or more testing machines TM1, TM2, TM3. FIG 1 shows that each printed circuit board PCB1, PCB2, PCB3 can be associated to a specific testing machine TM1, TM2, TM3, which is responsible for the testing of only this particular printed circuit board. However, it will be appreciated by a person skilled in the art that all printed circuit boards can be for example tested by a single testing machine. For this purpose, the printed circuit boards can be for example positioned on a conveyor, which can deliver the printed circuit boards to the ICT machine for the testing and carry the tested printed circuit boards away from the machine.

All printed circuit boards PCB1, PCB2, PCB3 can be of the same type. Many printed circuit boards of many different types can be tested.

After a test is performed, the ICT testing data TD, which comprises measurement data MDB of a plurality of electronic components of the printed circuit boards PCB1, PCB2, PCB3, can be forwarded to a system, where assignments ASG of printed circuit boards PCB1, PCB2, PCB3 are performed. Before arriving at the system as an input data ID, the testing data can be preprocessed (for example by a pre-processor PP) in some way or it can be forwarded as a raw data.

The input data ID is based on the ICT testing data TD of the printed circuit boards PCB1, PCB2, PCB3.

The system can comprise a first interface IF1, which is configured for receiving the input data ID. The system can also comprise a computation apparatus CU, configured for applying a trained classification function TCF to the input data ID in order to generate an output data. As depicted on FIG 1, the trained classification function TCF can be stored on the computation apparatus CU. In other embodiments the trained classification function TCF can be stored elsewhere, e.g. in a cloud or other any other repository remotely accessible from the computation apparatus.

In some embodiments the first interface IF1 can be a part of a gateway component GW (FIG 1). The trained classification function TCF can be stored on the gateway component GW (FIG 1). The gateway component GW can be a part of the computation apparatus CU (FIG 1).

The system can further comprise a second interface IF2, configured for providing the output data. The output data comprises assignments ASG of single electronic components of the tested printed circuit boards PCB1, PCB2, PCB3 to one of at least two different classes.

The system can be realized as an edge device.

Turing to FIG 2, an example of a computer-implemented method for assessing the tested printed circuit boards PCB1, PCB2, PCB3 of FIG 1 is depicted. The method can comprise:

| | |
|---|---|
| Step S1 | of receiving the input data ID, wherein the input data ID is based on the testing data TD of the printed circuit boards PCB1, PCB2, PCB3, wherein the testing data is an in-circuit test testing data and comprises measurement data MDB of a plurality of electronic components of the at least one printed circuit board PCB1, PCB2, PCB3; |
| Step S2 | of applying the trained classification function TCF to the input data ID, wherein the output data is generated; |
| Step S3 | of providing the output data, wherein the output data comprises the assignments ASG of the electronic components of each printed circuit board PCB1, PCB2, PCB3 to one of at least two different classes. In some embodiments the output data can be realized as input data ID augmented by the corresponding assignment ASG, e.g. labelled or categorized input data. |

The steps S1 to S3 can be carried out in the environment depicted in FIG 1. In particular, the method can be performed by the system, which is described with regard to FIG 1.

In some embodiments, one of the at least two classes corresponds to a category of pseudo-malfunctioning printed circuit boards. I.e. at least one of the plurality of the electronic components of the at least one printed circuit board has a pseudo-error ("false bad").

The "category of pseudo-malfunctioning printed circuit boards" contains printed circuit boards that have only pseudo-error(s), meaning that they are functioning printed circuit boards, but failed to pass the test, e.g. due to increased temperature of the printed circuit boards during the testing, which can lead to an overall drift of the measurement statistics. The term "pseudo-error" is broadly known in the field of printed circuit board testing.

In some embodiments each printed circuit board PCB1, PCB2, PCB3 is assigned to the group of three classes, more particular, to the group consisting of:
a first class, wherein the first class corresponds to a category of functioning printed circuit boards;
a second class, wherein the second class corresponds to a category of malfunctioning printed circuit boards, and
a third class, wherein the third class corresponds to the category of pseudo-malfunctioning printed circuit boards. In this case, the feature vector has three entries, e.g. "PASS" for functioning printed circuit boards, "FAIL" for malfunctioning printed circuit boards and "PSEUDO-ERROR" for functioning printed circuit boards with at least one pseudo-error.

In some embodiments, the trained classification function TCF can be based on a multi-variate classification algorithm, more particular, the multi-variate classification algorithm is an ordinary linear regression algorithm, a random forest algorithm, a gradient boosting algorithm, a LASSO algorithm, in particular, an adaptive LASSO algorithm, more particularly a linear regression algorithm with regularization, or a logistic regression algorithm, in particular, a binary logistic regression algorithm.

Various parameters of the printed circuit boards PCB1, PCB2, PCB3 can be measured, so that the ICT testing data TD can comprise measurement data of a plurality of the electrical parameters, e.g. at least one electrical parameter is measured for a plurality of electronic components, particularly for each electronic component of each printed circuit board PCB1, PCB2, PCB3. As mentioned above, in case of contaminated bad connections, a measurement of a resistance (electronic component) has a non-zero resistance value (a first electrical parameter) and also a non-zero capacitance (a second electrical parameter), which is compromising the measured value.

In some embodiments analog and/or digital electrical parameters of printed circuit boards PCB1, PCB2, PCB3 can be measured.

In some embodiments the measurements can comprise measurements of all electronic components, e.g. resistances, inductivities, capacities etc. of the printed circuit boards PCB1, PCB2, PCB3.

In some embodiments the input data ID and the output data comprise layout information of the tested printed circuit boards PCB1, PCB2, PCB3. For example, if printed circuit boards PCB1, PCB2, PCB3 of the same type are tested, then they have identical layout. It can be of an advantage if the measurement data MDB is visualized and the visualization utilizes the layout information. The visualization can be performed at the same time as the assignment ASG of a particular printed circuit board PCB1, PCB2 or PCB3 is provided.

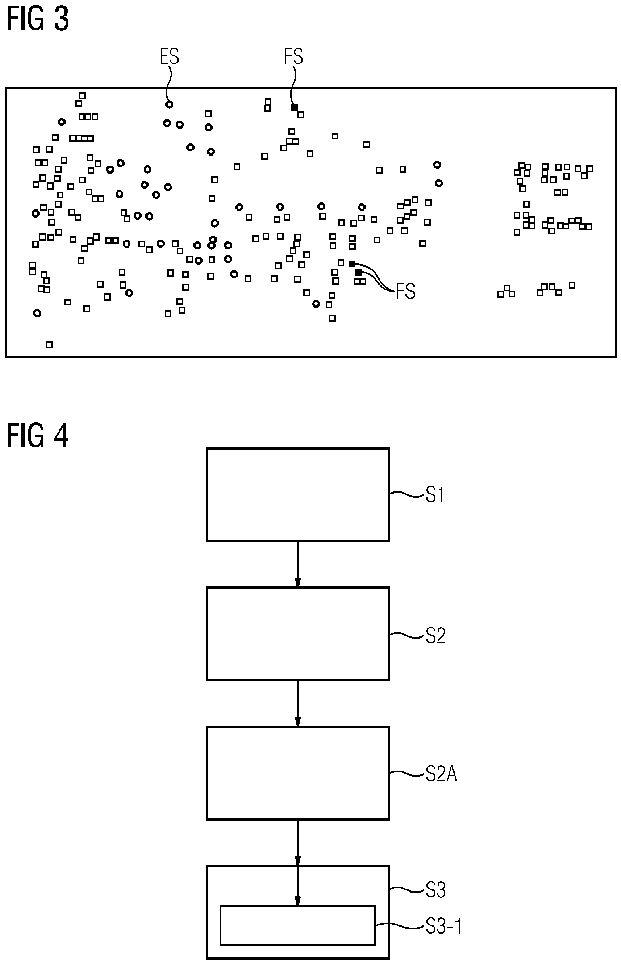

In some embodiments the visualization can be performed for example by means of a human machine interface HMI. Such HMI can be a part of the second interface IF2 of the computation apparatus CU and be co-located with the industrial plant PL (FIG 1) or with the cloud (not shown). An example of such visualization is depicted in FIG 3, where empty squares ES represent the positions on the printed circuit board, where it passed the test, i.e. the corresponding electronic component passes the test, and full squares FS represent the positions, where the printed circuit board failed the test, i.e. the corresponding electronic component fails the test.

In case, when various parameters of each printed circuit board are measured, the assignment ASG of a particular printed circuit board can be based on a plurality of single assignments, wherein each single assignment is an assignment of a particular parameter of that printed circuit board to one of the at least two, more particularly three, different classes. E.g. if all single assignments are "PASS", then the overall assignment ASG is also "PASS".

It will be appreciated that in order to pass the test the measured value of each parameter should lie within a prespecified allowed range of values. This pre-specified range of values can be determined in terms of statistical quantities/parameters. For example, such pre-specified range can be given in terms of a nominal value of the parameter (e.g. mean nominal value) and a confidence interval, e.g. of σ, 2σ, 3σ, 4σ or 5σ, wherein σ is a standard deviation.

Due to various interference factors, e.g. different temperature of the printed circuit boards PCB1, PCB2, PCB3 during the testing, remaining dirt after production etc., the predetermined range of values might not describe the actual behavior of the parameter properly. For example, the nominal value of a resistance can be determined to be R₀ at a room temperature, i.e. at about 25°C. During the measurement, however, the temperature of the printed circuit board undergoing the test can be higher (e.g. 50°C to 60°C or even higher) or lower than the room temperature. Due to this effect the predetermined nominal value of the resistance does not correspond to its nominal value in the real production environment. This can lead to a shift of the probability distribution describing the measurement of the parameter with respect to the predetermined nominal probability distribution. The measurement of parameters of the printed circuit boards PCB1, PCB2, PCB3 can be also described in terms of statistical parameters, e.g. in terms of location parameters and/or of spread parameters. Examples of such statistical parameters are standard deviation, variance, range, interquartile range, absolute deviation etc.

Therefore, the testing data TD of the printed circuit board(s) PCB1, PCB2, PCB3 can comprise predetermined allowed ranges of values for electrical parameters for electronic components of the printed circuit board as well as measured values of these electrical parameter(s), whose distributions can be compared with the predetermined allowed ranges of values.

In the state-of-the-art testing this range of values is specified by human experts, a test engineer, and does not depend on the recently performed measurements but is rather chosen according to design rules or experience and adjusted during the new product introduction process based on process data.

It will be appreciated that the "recently performed measurements" regard e.g. to the measurements, which have been performed during the last production cycle. For example, such recent measurements four weeks can be measurements of the last four weeks.

Turning to FIG 4, an embodiment is depicted, in which the method also comprises step S2A of optimizing at least one of predetermined statistical parameters that define an allowed range of values of a parameter of an electronic component of the at least one printed circuit board, in order to achieve an optimized value of the at least one predetermined statistical parameter, e.g. mean value, deviation, variance, range, interquartile range, absolute deviation etc., and Step 3 of providing the output data comprises a sub-step S3-1 of recommending the at least one optimized predetermined statistical parameter for use in the further testing.

The above-mentioned optimization can be performed based on recent historical testing data.

In some embodiments the optimization can be performed according to a heuristic mathematical model. For example, an optimized nominal value of a parameter, e.g. of a resistance, can be calculated based on parameter values, which were measured during the past four weeks for functioning printed circuit boards, i.e. for the printed circuit boards that passed the test. The optimized nominal value can be for example a mean value. The upper and lower bound of the confidence interval can be calculated e.g. for 5σ.

In some embodiments the recommending can be performed by means of a trained recommendation function TRF, more particularly, the trained recommendation function is based on a data-driven optimization, particularly on a distributionally robust optimization and/or an online linear programming algorithm and/or a least squares with nonconvex regularization and/or an alternating direction method of multipliers (ADMM) with multiple blocks.

The recommended optimized values of the predetermined statistical parameter(s) can be visualized, for example on the second interface.

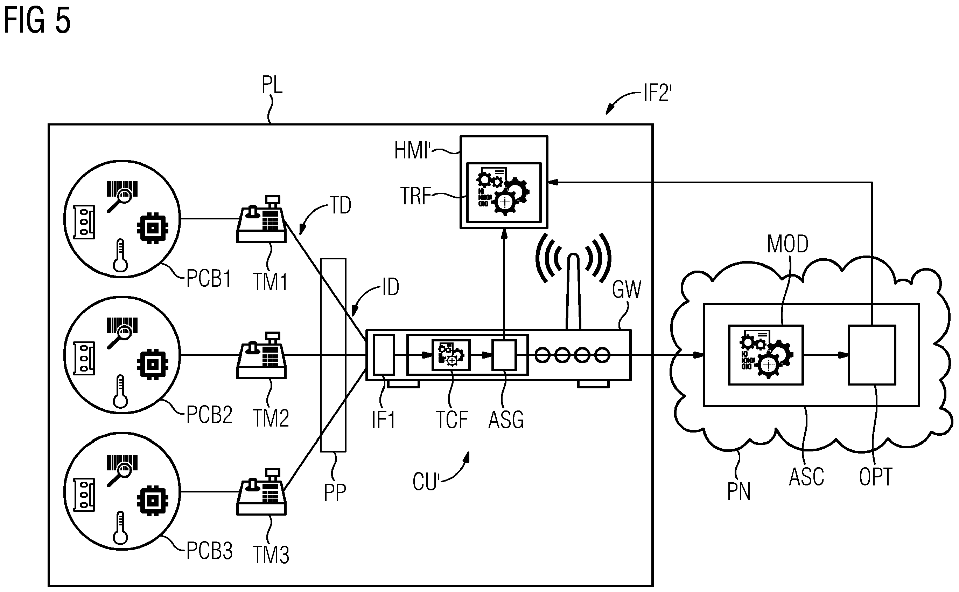

Turning to FIG 5, an example of an environment is illustrated, in which testing data of a plurality of printed circuit boards can be assessed, visualized and optimized parameters for further testing can be suggested.

Compared to the computation apparatus CU of FIG 1, the computation apparatus CU' of FIG 5 can be further configured for optimizing statistical parameter(s) in order to achieve an optimized (value of) statistical parameter(s) OPT. For this the computation apparatus CU' can comprise an additional hardware and/or software component. FIG 5 illustrates an embodiment, in which the computation apparatus CU' comprises an additional software component ASC, which, for example, can be situated in a public network PN, e.g. in a cloud.

The additional hardware and/or software component can comprise a model MOD for optimizing one or more nominal values of the parameters in the testing based on the recent data, e.g. the data from the same production cycle. For example, the model can be a heuristical mathematical model, which, based on the measurement data of the functioning printed circuit boards, evaluates mean value for each measured parameter. The model can also optimize further statistical parameters of the measured parameter, e.g. (allowed) deviation, variance, range, interquartile range, absolute deviation etc.

The second interface IF2' can be configured for recommending the optimized statistical parameter(s) OPT. For example, the second interface IF2' can suggest using the above-mentioned calculated mean value instead of the nominal value and/or optimized allowed value of deviation, variance, range, interquartile range, absolute deviation for use in the further testing.

For example, the optimized statistical parameters OPT can be calculated in the cloud PN and forwarded to the industrial plant PL (arrow in FIG 5). It will be appreciated that the optimized statistical parameters OPT can go through the gateway component GW or through another gateway component. E.g. the second interface IF2' can comprise an additional gateway component for receiving data from the cloud PN directly.

For example, the second interface IF2' can comprise visualization apparatus, e.g. a human-machine-interface HMI'. The human-machine-interface HMI' can be configured to visualize the optimized statistical parameters OPT (and the assignment ASG). The human-machine-interface HMI' can be also configured to receive the optimized statistical parameters OPT directly from the cloud PN.

The additional software component ASC can be also co-located with the industrial plant PL and be stored for example on the gateway component GW.

The above-mentioned trained recommendation function TRF for recommending/suggesting the optimized statistical parameters OPT can be stored on the second interface IF2'. More particularly, the trained recommendation function TRF can be stored on the human-machine-interface HMI' (FIG 5).

It will be appreciated that applying the trained classification function TCF and/or optimizing the predetermined statistical parameters to achieve the optimized statistical parameters OPT and/or applying the trained recommendation function TRF can be performed remotely. All these operations can be carried out in the cloud, such that the final products of the method, i.e. assignments ASG which can be optionally augmented by a recommendation of the optimized statistical parameters OPT, will be produced off-site and not at the industrial plant PL.

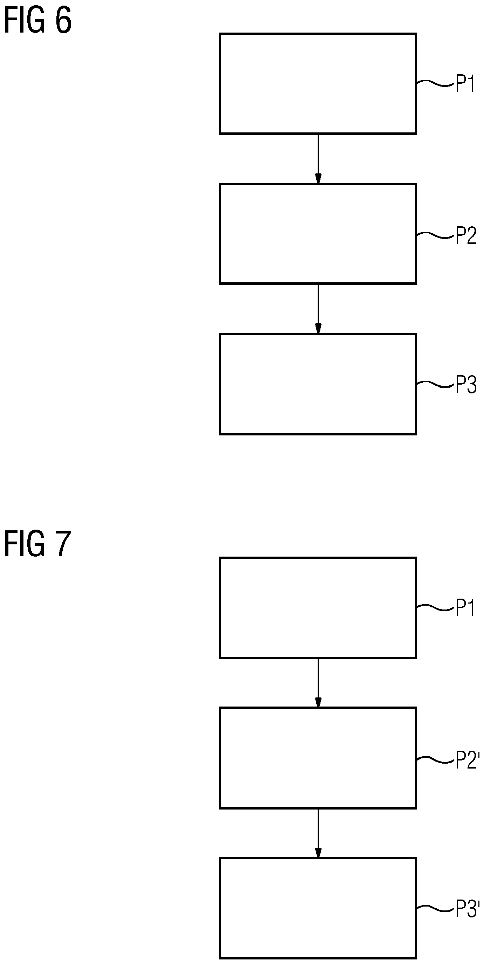

In particular, FIG 6 illustrates a method for producing a machine-readable data medium, which method comprises:

| | |
|---|---|
| Step P1 | of providing a machine-readable data medium; |
| Step P2 | of providing the assignment ASG of the at least one of the plurality of the electronic components of the at least one printed circuit board PCB1, PCB2, PCB3 to the one of at least two classes, as described above, and |
| Step P3 | of storing the assignment ASG on the machine-readable data medium. |

More particularly, the step of providing the assignment(s) ASG can also comprise providing the at least one optimized statistical parameter OPT for further testing - step P2' in FIG 7 - and the step of storing the assignment(s) ASG on the machine-readable data medium can comprise storing the at least one optimized statistical parameter OPT for further testing on the machine-readable data medium - step P3' in FIG 7.

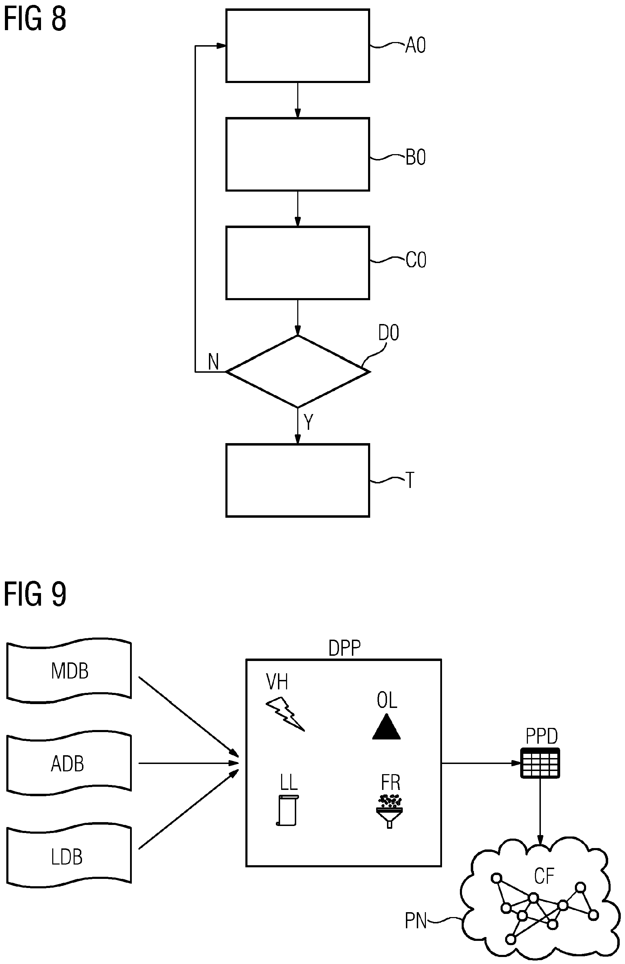

Considering the above, FIG 8 illustrates an example of a computer-implemented method for providing a trained classification function TCF. The method can comprise step A0 of receiving training input data and training output data, wherein the training input data is representative of the in-circuit test testing data TD, wherein the ICT testing data TD comprises measurement data MDB of a plurality of electronic components of the printed circuit boards PCB1, PCB2, PCB3 and the training output data is representative of the assignments ASG of at least one of the plurality of the electronic components, wherein each assignment ASG is an assignment of the at least one of the plurality of the electronic components to the one of at least two different classes. The method can further comprise a step B0 of executing a classification function on the training input data in order to generate predicted training output data, a step C0 of comparing the training output data to the predicted training output data in order to determine an error, a step D0 of updating the classification function in accordance with the determined error. If, for example, the determined error was not satisfactory, the steps A0 to D0 can be repeated in an iterative manner to reduce the error (model fitting), otherwise the method can be terminated T.

The comparing - step C0 - can be performed using a confusion matrix.

The classification function can be based on a multi-variate classification algorithm, for example, on an ordinary linear regression algorithm, on a random forest algorithm, on a gradient boosting algorithm, on a LASSO algorithm, in particular, on an adaptive LASSO algorithm, more particularly on a linear regression algorithm with regularization, or on a logistic regression algorithm, in particular, on a binary logistic regression algorithm.

The method can be performed using different classification functions, wherein the end results are compared after fitting is done. In this way the training method can comprise performing steps A0 to D0 for different classification functions, e.g. in parallel, and choosing the best performing model/algorithm after the training is finished.

In some embodiments the method can further comprise a step of cross-validation.

In some embodiments the method can comprise data-preprocessing, which can be performed before step A0. The preprocessing of the training data can be performed also on the testing data TD, e.g. by the pre-processor PP.

A substep of cross-validation - the step of splitting an entire dataset into a training dataset and a validation dataset can be a part of such preprocessing. The training dataset consists of training input data and training output data. Such training dataset can be testing data of a part of the plurality of the printed circuit boards, e.g. only of PCB1, i.e. the training input data, augmented by the corresponding assignments, i.e. the training output data.

Therefore, the training dataset can constitute a part of the entire dataset, so that a probability of overfitting the model is reduced. Particularly good results can be achieved if the training dataset constitutes about 20% of the entire dataset. Further improvements can be achieved if the cross-validation is performed and always new training dataset is chosen from the entire dataset. Even better results are achieved, if the new training dataset does not overlap any of older training datasets. In this way the training data is always "fresh".

Turning to FIG 9 an example of data-preprocessing is illustrated. This data-preprocessing is applicable both to the training data and to the testing data TD.

First, the data is received from one or more data sources. FIG 9 depicts an embodiment with three data sources:
measurement data MDB of the printed circuit boards (raw data), e.g. data of ICT measurements; assignments data ADB, which is based on assignments, e.g. by human experts or by a machine learning algorithm, of the electronic components of the printed circuit boards to different classes, e.g. two or three different classes, and layout information LDB of the printed circuit boards, e.g. for further visualisation of the results.

The measurement data MDB can be provided for example in form of .csv format files and can comprise millions, e.g. about 4 to 5 millions of entries, which correspond to the measurements of different electrical parameters of the printed circuit boards. The assignment data ADB can be provided for example in form of .xls format files and can comprise thousands, e.g. about 6 to 7 thousands of entries. The measurement data MDB can be provided for example in form of .pcf format files.

This data can be pre-processed DPP as follows. The preprocessing can be performed in an automated manner. In an embodiment, a violation history VH (of the printed circuit boards) can be created. The violation history can comprise time(s) of passing measurement cycle, first/last pass, time(s) of failing measurement cycle, first/last fail, number of threshold violations, whereing the threshold determine the allowable range of values of a (measured) parameter of the printed circuit boards.

In a embodiment a labelling LL of the measurement data MDB based on the assignment data ADB can be performed. The labelling can coprise preparation of labels for two or more categories, e.g. for first pass "PASS", for pseudo-errors "PSEUDO-ERROR" and for pure failures "FAIL". In this manner supervised learning can be enabled in an easy manner.

To handle the violation information as well the experts information (on thresholds) in a better way, outliers can be logarithmized OL beyond the thresholds, i.e. outside of the range of allowed values.

To reduce features principal component analysis (PCA), correlation analysis and/or variation coefficient considerations can be performed FR.

The pre-proccessed data PPD or a part of it, if e.g. a cross-validation is performed, can be then provided as trainng dataset to the classification function CF, which can be located in the cloud PN.

It will be appreciated that the measurement data MDB, the assignment data ADB etc. can be provided in a cloud or in form of a data lake, which can be co-located with the industrial plant PL or be in the cloud PN or even be distributed between the industrial plant PL and the cloud PN. The data lake can comprise a manufacturing data lake. These data bases can be updated by the results of implementing the above-described methods, e.g. by the assignments ASG and/or by the optimized statistical parameters OPT.

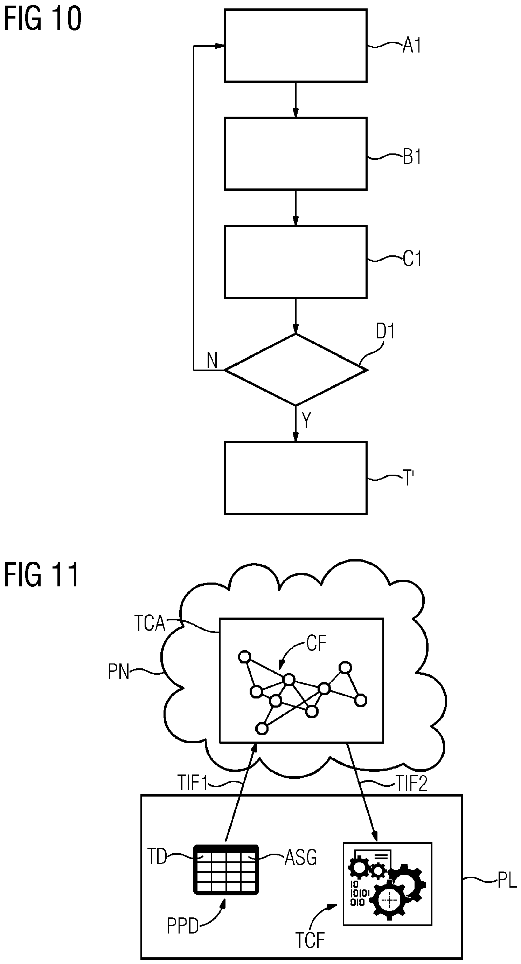

Turning to FIG 10 an example of a computer-implemented method for providing the trained recommendation function TRF for printed circuit board testing, comprising:

| | |
|---|---|
| step A1 | of receiving training input data and training output data, wherein the training input data is representative of recommendations of at least one optimized statistical parameter OPT, wherein statistical parameters determine a pre-specified range of values of at least one electrical parameter of each electronic component of a plurality of electronic components of the at least one printed circuit board, wherein the pre-specified range of values comprise values that are allowed during printed circuit board testing and the training output data is representative of acceptance of the recommendations; |
| step B1 | of executing a recommendation function on the training input data in order to generate predicted training output data; |
| a step C1 | of comparing the training output data to the predicted training output data in order to determine an error; |
| a step D1 | of updating the recommendation function in accordance with the determined error, and, if e.g. the error is not yet satisfactory, performing the steps B1 to D1 in an iterative manner to (further) reduce the error. Otherwise the method can be terminated T' . |

In some embodiments the recommendation function can be based on a data-driven optimization, particularly on a distributionally robust optimization and/or an online linear programming algorithm and/or a least squares with nonconvex regularization and/or an alternating direction method of multipliers (ADMM) with multiple blocks.

FIG 11 shows an example of a training system for providing the trained classification function TCF (or the trained recommendation function TRF, as explained below). The training system can comprise soft- and/or hardware components. The training system can be located in the public network PN, e.g. in the cloud (shown in FIG 11). It can be also co-located with the industrial plant PL (not shown). The training system can be distributed between industrial plant PL and the public network PN. For example, it can be of advantage to use cloud resources for handling big amount of the testing data DT and/or for executing the classification or recommendation function.

The training system can comprise a first training interface TIF1, configured for receiving training input data and training output data, e.g. in form of pre-processed training data PPD, wherein the training input data is representative of a ICT testing data TD of printed circuit boards PCB1, PCB2, PCB3, wherein the ICT testing data comprises measurement data MDB of a plurality of electronic components of the at least one printed circuit board and the training output data is representative of assignments ASG of at least one, particularly of each of the plurality of the electronic components of the printed circuit boards PCB1, PCB2, PCB3, wherein each assignment is an assignment of an electronic component of a printed circuit board to one of at least two, more particularly, three different classes and different assignements correspond to different electronic components. The training system can further comprise a training computation apparatus TCA, configured for executing a classification function CF on the training input data in order to generate predicted training output data; comparing the training output data to the predicted training output data in order to determine an error, and for updating the classification function in accordance with the determined error. Furthermore, the training system can comprise a second training interface TIF2, configured for providing the trained classification function.

The training system shown in FIG 11 can be also used to train the trained recommendation function TRF, if the training input data is representative of recommendations of at least one optimized statistical parameter OPT, the training output data is representative of acceptance of the recommendations and the training computation apparatus TCA is configured for executing a recommendation function.

The above described embodiments of the present disclosure are presented for purposes of illustration and not of limitation. In particular, the embodiments described with regard to figures are only few examples of the embodiments described in the introductory part.

The reference signs in the claims used only for clarity purposes and shall not be considered to be a limiting part of the claims.

Features, advantages or alternative embodiments herein can be assigned to the other claimed objects and vice versa. In other words, claims for the providing systems can be improved with features described or claimed in the context of the methods. In this case, the functional features of the Method are embodied by objective units of the providing system.

"Furthermore, in the following the solution according to the invention is described with respect to methods and systems for utilization of trained functions as well as with respect to methods and systems for providing the trained functions. Features, advantages or alternative embodiments herein can be assigned to the other claimed objects and vice versa. In other words, claims for methods and systems for providing the trained functions can be improved with features described or claimed in context of the methods and systems for utilization of the trained functions, and vice versa.

In particular, the trained (machine learning) function or algorithm of the methods and systems can be adapted by the methods and systems for providing the trained function. Furthermore, the input data can comprise advantageous features and embodiments of the training input data, and vice versa. Furthermore, the output data can comprise advantageous features and embodiments of the output training data, and vice versa.

In general, a trained function mimics cognitive functions that humans associate with other human minds. In particular, by training based on training data the trained function is able to adapt to new circumstances and to detect and extrapolate patterns.

In general, parameters of a trained function can be adapted by means of training. In particular, for training of the recommendation function supervised training, semi-supervised training, unsupervised training, reinforcement learning and/or active learning can be used. Furthermore, representation learning (an alternative term is "feature learning") can be used. In particular, the parameters of the trained functions can be adapted iteratively by several steps of training.

In particular, a trained function can comprise a neural network, a support vector machine, a decision tree and/or a Bayesian network, and/or the trained function can be based on k-means clustering, Q-learning, genetic algorithms and/or association rules. In particular, a neural network can be a deep neural network, a convolutional neural network or a convolutional deep neural network. Furthermore, a neural network can be an adversarial network, a deep adversarial network and/or a generative adversarial network.

## Claims

1. A computer-implemented method for assessing at least one printed circuit board (PCB1, PCB2, PCB3), comprising:
- receiving input data (ID), wherein the input data (ID) is based on a testing data (TD) of at least one printed circuit board (PCB1, PCB2, PCB3), wherein the testing data is an in-circuit test testing data and comprises measurement data (MDB) of a plurality of electronic components of the at least one printed circuit board (PCB1, PCB2, PCB3);
- applying a trained classification function (TCF) to the input data (ID), wherein an output data is generated;
- providing the output data, wherein the output data comprises an assignment (ASG) of at least one of the plurality of the electronic components of the at least one printed circuit board (PCB1, PCB2, PCB3) to one of at least two different classes.

2. Method of Claim 1, wherein the trained classification function (TCF) is based on a multi-variate classification algorithm, more particular, the multi-variate classification algorithm is an ordinary linear regression algorithm, a random forest algorithm, a gradient boosting algorithm, a LASSO algorithm, in particular, an adaptive LASSO algorithm, more particularly a linear regression algorithm with regularization, or a logistic regression algorithm, in particular, a binary logistic regression algorithm.

3. Method of Claim 1 or 2, wherein one of the at least two classes corresponds to a category of pseudo-malfunctioning printed circuit boards.

4. Method of Claim 3, wherein the at least one printed circuit board is assigned to the group of three classes, more particular, to the group consisting of:
a first class, wherein the first class corresponds to a category of functioning printed circuit boards;
a second class, wherein the second class corresponds to a category of malfunctioning printed circuit boards, and
a third class, wherein the third class corresponds to the category of pseudo-malfunctioning printed circuit boards.

5. Method of any one of Claims 1 to 4, wherein the measurement data (MDB) of the plurality of the electronic components of the at least one printed circuit board (PCB1, PCB2, PCB3) comprises measurement data of at least one electrical parameter of each electronic component of the plurality of the electronic components of the at least one printed circuit board (PCB1, PCB2, PCB3).

6. Method of Claim 5, wherein the input data and the output data comprise layout information of the at least one printed circuit board and the providing the output data comprises visualizing the measurement data (MDB) of the at least one electrical parameter of each electronic component of the plurality of the electronic components of the at least one printed circuit board, based on the layout information.

7. Method of Claim 5 or 6, further comprising
- optimizing at least one of statistical parameters, wherein the statistical parameters determine a pre-specified allowed range of values of the at least one electrical parameter of each electronic component of the plurality of the electronic components of the at least one printed circuit board, wherein
providing the output data comprises
- recommending the at least one optimized statistical parameter (OPT) for use in the further testing.

8. Method of Claim 7, wherein the recommending is performed by means of a trained recommendation function (TRF), more particularly, the trained recommendation function is based on a data-driven optimization, particularly on a distributionally robust optimization and/or an online linear programming algorithm and/or a least squares with nonconvex regularization and/or an alternating direction method of multipliers with multiple blocks.

9. Method of any one of Claims 1 to 8, wherein providing a trained classification function (TCF) comprises:
A0) receiving training input data and training output data, wherein the training input data is representative of an in-circuit test testing data (TD), wherein the ICT testing data comprises measurement data of a plurality of electronic components of the at least one printed circuit board (PCB1, PCB2, PCB3) and the training output data is representative of assignments (ASG) of at least one of the plurality of the electronic components of the printed circuit boards (PCB1, PCB2, PCB3), wherein each assignment is an assignment of the at least one of the plurality of the electronic components to one of at least two different classes;
B0) executing a classification function (CF) on the training input data in order to generate predicted training output data;
C0) comparing the training output data to the predicted training output data in order to determine an error;
D0) updating the classification function in accordance with the determined error, and
E0) performing the steps A0) to D0) in an iterative manner to reduce the error.

10. Method of Claim 8, wherein providing a trained recommendation function (TRF) for printed circuit board testing comprises:
A1) receiving training input data and training output data, wherein the training input data is representative of recommendations of at least one optimized statistical parameter (OPT), wherein statistical parameters determine a pre-specified range of values of at least one electrical parameter of each electronic component of a plurality of electronic components of the at least one printed circuit board, wherein the pre-specified range of values comprise values that are allowed during printed circuit board testing and the training output data is representative of acceptance of the recommendations;
B1) executing a recommendation function on the training input data in order to generate predicted training output data;
C1) comparing the training output data to the predicted training output data in order to determine an error;
D1) updating the recommendation function in accordance with the determined error, and
E1) performing the steps A1) to D1) in an iterative manner to reduce the error.

11. A computer program comprising instructions which, when the program is executed by a system, cause the system to carry out the Method of one of the Claims 1 to 10.

12. A system, comprising
- a first interface (IF1), configured for receiving input data (ID), wherein the input data (ID) is based on a testing data of at least one printed circuit board, wherein the testing data is an in-circuit test testing data and comprises measurement data (MDB) of a plurality of electronic components of the at least one printed circuit board (PCB1, PCB2, PCB3);
- a computation apparatus (CU, CU'), configured for applying a trained classification function (TCF) to the input data (ID) to generate an output data;
- a second interface (IF2, IF2'), configured for providing the output data, wherein the output data comprises an assignment (ASG) of at least one of the plurality of the electronic components of the at least one printed circuit board to one of at least two different classes.

13. System of Claim 12, wherein the computation apparatus (CU') or the second interface (IF2') is configured for
- optimizing at least one of statistical parameters, wherein the statistical parameters determine a pre-specified range of allowed values of at least one electrical parameter of each electronic component of the plurality of the electronic components of the at least one printed circuit board, wherein
the computation apparatus (CU') or the second interface (IF2') is configured for
- recommending, more particularly by applying a trained recommendation function (TRF), the at least one optimized statistical parameter (OPT) for use in the further testing, while providing the output data.

## Patentansprüche

1. Computerimplementiertes Verfahren zum Bewerten mindestens einer Leiterplatte (PCB1, PCB2, PCB3), Folgendes umfassend:
- Empfangen von Eingangsdaten (ID), wobei die Eingangsdaten (ID) auf Testdaten (TD) mindestens einer Leiterplatte (PCB1, PCB2, PCB3) basieren, wobei die Testdaten Testdaten schaltkreisinterner Tests sind und Messdaten (MBD) mehrerer elektronischer Komponenten der mindestens einen Leiterplatte (PCB1, PCB2, PCB3) umfassen,
- Anwenden einer trainierten Klassifizierungsfunktion (TCF) auf die Eingangsdaten (ID), wobei Ausgangsdaten erzeugt werden,
- Bereitstellen der Ausgangsdaten, wobei die Ausgangsdaten eine Zuordnung (ASG) mindestens einer der mehreren elektronischen Komponenten der mindestens einen Leiterplatte (PCB1, PCB2, PCB3) zu einer von zwei verschiedenen Klassen umfassen.

2. Verfahren nach Anspruch 1, wobei die trainierte Klassifizierungsfunktion (TCF) auf einem multivariaten Klassifizierungsalgorithmus basiert, der multivariate Klassifizierungsalgorithmus insbesondere ein gewöhnlicher Lineare-Regressios-Algorithmus, ein Random-Forrest-Algorithmus, ein Gradient-Boosting-Algorithmus, ein LASSO-Algorithmus, insbesondere ein adaptiver LASSO-Algorithmus, noch spezieller ein Lineare-Regression-Algorithmus mit Regularisierung oder ein Logistische-Regression-Algorithmus, insbesondere ein binärer Logistische-Regression-Algorithmus ist.

3. Verfahren nach Anspruch 1 oder 2, wobei eine der mindestens zwei Klassen einer Kategorie pseudo-fehlfunktionierender Leiterplatten entspricht.

4. Verfahren nach Anspruch 3, wobei die mindestens eine Leiterplatte der Gruppe von drei Klassen zugeordnet wird, insbesondere der Gruppe, die aus Folgendem besteht:
einer ersten Klasse, wobei die erste Klasse einer Kategorie funktionierender Leiterplatten entspricht,
einer zweiten Klasse, wobei die zweite Klasse einer Kategorie fehlfunktionierender Leiterplatten entspricht, und einer dritten Klasse, wobei die dritte Klasse der Kategorie pseudo-fehlfunktionierender Leiterplatten entspricht.

5. Verfahren nach einem der Ansprüche 1 bis 4, wobei die Messdaten (MDB) der mehreren elektronischen Komponenten der mindestens einer Leiterplatte (PCB1, PCB2, PCB3) Messdaten mindestens eines elektrischen Parameters jeder elektronischen Komponente der mehreren elektronischen Komponenten der mindestens einen Leiterplatte (PCB1, PCB2, PCB3) umfassen.

6. Verfahren nach Anspruch 5, wobei die Eingangsdaten und die Ausgangsdaten Layout-Informationen der mindestens einen Leiterplatte umfassen und das Bereitstellen der Ausgangsdaten das Visualisieren der Messdaten (MDB) des mindestens einen elektrischen Parameters jeder elektronischen Komponente der mehreren elektronischen Komponenten der mindestens einen Leiterplatte basierend auf den Layout-Informationen umfasst.

7. Verfahren nach Anspruch 5 oder 6, ferner Folgendes umfassend:
- Optimieren mindestens eines von statistischen Parametern, wobei die statistischen Parameter einen vorab spezifizierten zulässigen Bereich von Werten des mindestens einen elektrischen Parameters jeder elektronischen Komponente der mehreren elektronischen Komponenten der mindestens einen Leiterplatte bestimmen, wobei
das Bereitstellen der Ausgangsdaten Folgendes umfasst:
- Empfehlen des mindestens einen optimierten statistischen Parameters (OPT) zur Verwendung bei weiteren Tests.

8. Verfahren nach Anspruch 7, wobei das Empfehlen mittels einer trainierten Empfehlungsfunktion (TRF) durchgeführt wird, wobei die trainierte Empfehlungsfunktion insbesondere auf einer datengesteuerten Optimierung basiert, insbesondere auf einer distributiv robusten Optimierung und/oder einem Online-Linear-Programmierungs-Algorithmus und/oder einem Verfahren der kleinsten Quadrate mit nichtkonvexer Regularisierung und/oder einem Wechselrichtungsverfahren von Multiplikatoren mit mehreren Blöcken.

9. Verfahren nach einem der Ansprüche 1 bis 8, wobei das Bereitstellen einer trainierten Klassifizierungsfunktion (TCF) Folgendes umfasst:
A0) Empfangen von Trainingseingangsdaten und Trainingsausgangsdaten, wobei die Trainingseingangsdaten eine Darstellung von Testdaten (TD) schaltkreisinterner Tests sind, wobei die ICT-Testdaten Messdaten mehrerer elektronischer Komponenten der mindestens einen Leiterplatte (PCB1, PCB2, PCB3) umfassen, und die Trainingsausgangsdaten eine Darstellung von Zuordnungen (ASG) mindestens einer der mehreren elektronischen Komponenten der Leiterplatten (PCB1, PCB2, PCB3) sind, wobei jede Zuordnung eine Zuordnung der mindestens einen der mehreren elektronischen Komponenten zu einer von mindestens zwei verschiedenen Klassen ist,
B0) Ausführen einer Klassifizierungsfunktion (CF) an den Trainingseingangsdaten, um vorhergesagte Trainingsausgangsdaten zu erzeugen,
C0) Vergleichen der Trainingsausgangsdaten mit den vorhergesagten Trainingsausgangsdaten, um einen Fehler zu bestimmen,
D0) Aktualisieren der Klassifizierungsfunktion gemäß dem bestimmten Fehler und
E0) Durchführen der Schritte A0) bis D0) in iterativer Weise, um den Fehler zu reduzieren.

10. Verfahren nach Anspruch 8, wobei das Bereitstellen einer trainierten Empfehlungsfunktion (TRF) für das Testen von Leiterplatten Folgendes umfasst:
A1) Empfangen von Trainingseingangsdaten und Trainingsausgangsdaten, wobei die Trainingseingangsdaten eine Darstellung von Empfehlungen mindestens eines optimierten statistischen Parameters (OPT) sind, wobei statistische Parameter einen vorab spezifizierten Bereich von Werten mindestens eines elektrischen Parameters jeder elektronischen Komponente von mehreren elektronischen Komponenten der mindestens einen Leiterplatte ist, wobei der vorab spezifizierte Bereich von Werten Werte umfasst, die während des Testens der Leiterplatte zulässig sind, und die Trainingsausgangsdaten eine Darstellung der Akzeptanz der Empfehlungen sind,
B1) Ausführen einer Empfehlungsfunktion an den Trainingseingangsdaten, um vorhergesagte Trainingseingangsdaten zu erzeugen,
C1) Vergleichen der Trainingsausgangsdaten mit den vorhergesagten Trainingsausgangsdaten, um einen Fehler zu bestimmen,
D1) Aktualisieren der Empfehlungsfunktion gemäß dem bestimmten Fehler und
E1) Durchführen der Schritte A1) bis D1) in iterativer Weise, um den Fehler zu reduzieren.

11. Computerprogramm, Anweisungen umfassend, die bei Ausführung des Programms durch ein System das System veranlassen, das Verfahren nach einem der Ansprüche 1 bis 10 auszuführen.

12. System, Folgendes umfassend:
- eine erste Schnittstelle (IF1), die für das Empfangen von Eingangsdaten (ID) konfiguriert ist, wobei die Eingangsdaten (ID) auf Testdaten mindestens einer Leiterplatte basieren, wobei die Testdaten Testdaten schaltkreisinterner Tests sind und Messdaten (MBD) mehrerer elektronischer Komponenten der mindestens einen Leiterplatte (PCB1, PCB2, PCB3) umfassen,
- eine Rechenvorrichtung (CU, CU`), die zum Anwenden einer trainierten Klassifizierungsfunktion (TCF) auf die Eingangsdaten (ID) konfiguriert ist, um Ausgangsdaten zu erzeugen,
- eine zweite Schnittstelle (IF2, IF2`), die zum Bereitstellen der Ausgangsdaten konfiguriert ist, wobei die Ausgangsdaten eine Zuordnung (ASG) mindestens einer der mehreren elektronischen Komponenten der mindestens einen Leiterplatte zu einer von mindestens zwei verschiedenen Klassen umfassen.

13. System nach Anspruch 12, wobei die Rechenvorrichtung (CU') oder die zweite Schnittstelle (IF2') für Folgendes konfiguriert ist:
- Optimieren mindestens eines von statistischen Parametern, wobei die statistischen Parameter einen vorab spezifizierten Bereich von zulässigen Werten mindestens eines elektrischen Parameters jeder elektronischen Komponente der mehreren elektronischen Komponenten der mindestens einen Leiterplatte bestimmen, wobei
die Rechenvorrichtung (CU') oder die zweite Schnittstelle (IF2') für Folgendes konfiguriert ist:
- Empfehlen des mindestens einen optimierten statistischen Parameters (OPT) zur Verwendung bei weiteren Tests, insbesondere durch Anwenden einer trainierten Empfehlungsfunktion (TRF), während des Bereitstellens der Ausgangsdaten.

## Revendications

1. Procédé mis en œuvre par ordinateur d'évaluation d'au moins une plaquette (PCB1, PCB2, PCB3) à circuit imprimé, comprenant :
- recevoir une donnée (ID) d'entrée, dans lequel la donnée (ID) d'entrée repose sur une donnée (TD) de test d'au moins une plaquette (PCB1, PCB2, PCB3) à circuit imprimé, dans lequel la donnée de test est une donnée de test en circuit et comprend une donnée (MDB) de mesure d'une pluralité de composants électroniques de la au moins une plaquette (PCB1, PCB2, PCB3) à circuit imprimé ;
- appliquer une fonction (TCF) de classement d'apprentissage à la donnée (ID) d'entrée, une donnée de sortie étant créée ;
- donner la donnée de sortie, dans lequel la donnée de sortie comprend une affectation (ASG) d'au moins l'un de la pluralité de composants électroniques de la au moins une plaquette (PCB1, PCB2, PCB3) à circuit imprimé à l'une d'au moins deux classes différentes.

2. Procédé suivant la revendication 1, dans lequel la fonction (TCF) de classement d'apprentissage repose sur un algorithme de classement multivarié, plus particulièrement l'algorithme de classement multivarié est un algorithme ordinaire de régression linéaire, un algorithme à forêt d'arbres décisionnels, un algorithme à boosting de gradient, un algorithme LASSO, en particulier un algorithme LASSO adaptatif, plus particulièrement un algorithme à régression linéaire avec régularisation, ou un algorithme à régression logistique, en particulier un algorithme à régression logistique binaire.

3. Procédé suivant la revendication 1 ou 2, dans lequel l'une des au moins deux classes correspond à une catégorie de plaquettes à circuit imprimé pseudo-dysfonctionnant.

4. Procédé suivant la revendication 3, dans lequel la au moins une plaquette à circuit imprimé est affectée au groupe de trois classes, plus particulièrement au groupe consistant en :
une première classe, dans lequel la première classe correspond à une catégorie de plaquettes à circuit imprimé fonctionnant ;
une deuxième classe, dans lequel la deuxième classe correspond à une catégorie de plaquettes à circuit imprimé dysfonctionnant, et
une troisième classe, dans lequel la troisième classe correspond à la catégorie de plaquettes à circuit imprimé pseudo-dysfonctionnant.

5. Procédé suivant l'une quelconque des revendications 1 à 4, dans lequel la donnée (MDB) de mesure de la pluralité de composants électroniques de la au moins une plaquette (PCB1, PCB2, PCB3) à circuit imprimé comprend une donnée de mesure d'au moins un paramètre électrique de chaque composant électronique de la pluralité de composants électroniques de la au moins une plaquette (PCB1, PCB2, PCB3) à circuit imprimé.

6. Procédé suivant la revendication 5, dans lequel la donnée d'entrée et la donnée de sortie comprennent une information d'implantation de la au moins une plaquette de circuit imprimé et donner la donnée de sortie comprend visualiser la donnée (MDB) de mesure du au moins un paramètre électrique de chaque composant électronique de la pluralité des composants électroniques de la au moins une plaquette à circuit imprimé sur la base de l'information d'implantation.

7. Procédé suivant la revendication 5 ou 6, comprenant en outre
- optimiser au moins l'un des paramètres statistiques, dans lequel les paramètres statistiques déterminent une plage autorisée précisée à l'avance de valeurs du au moins un paramètre électrique de chaque composant électronique de la pluralité des composants électroniques de la au moins une plaquette à circuit imprimé, dans lequel
donner la donnée de sortie comprend
- recommander d'utiliser pour le test ultérieur le au moins un paramètre (OPT) statistique optimisé.

8. Procédé suivant la revendication 7, dans lequel on effectue la recommandation au moyen d'une fonction (TRF) de recommandation d'apprentissage, plus particulièrement, la fonction de recommandation d'apprentissage repose sur une optimisation commandée par donnée, en particulier sur une optimisation robuste distributionnellement et/ou sur un algorithme de programmation linéaire en ligne et/ou sur des moindres carrés avec régularisation non convexe et/ou un procédé de direction alternée de multiplicateurs par des blocs multiples.

9. Procédé suivant l'une quelconque des revendications 1 à 8, dans lequel se procurer une fonction (TCF) de classement d'apprentissage comprend :
A0) recevoir une donnée d'entrée d'apprentissage et une donnée de sortie d'apprentissage, dans lequel la donnée d'entrée d'apprentissage est représentative d'une donnée (TD) de test en circuit, dans lequel la donnée de test ICT comprend une donnée de mesure d'une pluralité de composants électroniques de la au moins une plaquette (PCB1, PCB2, PCB3) à circuit imprimé et la donnée de sortie d'apprentissage est représentative d'affectations (ASG) d'au moins l'un de la pluralité des composants électroniques de la plaquette (PCB1, PCB2, PCB3) à circuit imprimé, dans lequel chaque affectation est une affectation du au moins un de la pluralité des composants électroniques à l'une d'au moins deux classes différentes ;
B0) exécuter une fonction (CF) de classement sur la donnée d'entrée d'apprentissage afin de créer une donnée de sortie d'apprentissage prédite ;
C0) comparer la donnée de sortie d'apprentissage à la donnée de sortie d'apprentissage prédite afin de déterminer une erreur ;
D0) mettre à jour la fonction de classement en fonction de l'erreur déterminée, et
E0) effectuer les stades A0) à D0) d'une manière itérative pour réduire l'erreur.

10. Procédé suivant la revendication 8, dans lequel se procurer une fonction (TRF) de recommandation d'apprentissage pour un test de plaquette à circuit imprimé, comprend :
A1) recevoir une donnée d'entrée d'apprentissage et une donnée de sortie d'apprentissage, dans lequel la donnée d'entrée d'apprentissage est représentative de recommandations d'au moins un paramètre (OPT) statistique optimisé, dans lequel des paramètres statistiques déterminent une plage précisée à l'avance de valeurs d'au moins un paramètre électrique de chaque composant électronique d'une pluralité de composants électroniques de la au moins une plaquette à circuit imprimé, dans lequel la plage précisée à l'avance de valeurs comprend des valeurs qui sont autorisées pendant le test de la plaquette à circuit imprimé et la donnée de sortie d'apprentissage est représentative d'une acceptation des recommandations ;
B1) exécuter une fonction de recommandation sur la donnée d'entrée d'apprentissage afin de créer une donnée de sortie d'apprentissage prédite ;
C1) comparer la donnée de sortie d'apprentissage à la donnée de sortie d'apprentissage prédite afin de déterminer une erreur ;
D1) mettre à jour la fonction de recommandation en accord avec l'erreur déterminée, et
E1) effectuer les stades A1) à D1) d'une manière itérative pour réduire l'erreur.

11. Programme d'ordinateur comprenant des instructions qui, lorsque le programme est exécuté par un système, font que le système effectue le procédé suivant l'une des revendications 1 à 10.

12. Système, comprenant
- une première interface (IF1), configurée pour recevoir une donnée (ID) d'entrée, dans lequel la donnée (ID) d'entrée repose sur une donnée de test d'au moins une plaquette à circuit imprimé, dans lequel la donnée de test est une donnée de test en circuit et comprend une donnée (MDB) de mesure d'une pluralité de composants électroniques de la au moins une plaquette (PCB1, PCB2, PCB3) à circuit imprimé ;
- une installation (CU, CU') informatique, configurée pour appliquer une fonction (TCF) de classement d'apprentissage à la donnée (ID) d'entrée pour créer une donnée de sortie ;
- une deuxième interface (IF2, IF2'), configurée pour donner la donnée de sortie, dans lequel la donnée de sortie comprend une affectation (ASG) d'au moins l'un de la pluralité de composants électroniques de la au moins une plaquette à circuit imprimé à l'une d'au moins deux classes différentes.

13. Système suivant la revendication 12, dans lequel l'installation (CU') informatique ou la deuxième interface (IF2') est configurée pour
- optimiser au moins l'un des paramètres statistiques, dans lequel les paramètres statistiques déterminent une plage autorisée précisée à l'avance de valeurs du au moins un paramètre électrique de chaque composant électronique de la pluralité des composants électroniques de la au moins une plaquette à circuit imprimé,
dans lequel
l'installation (CU') informatique ou la deuxième interface (IF2') est configurée pour
- recommander, plus particulièrement en appliquant une fonction (TRF) de recommandation d'apprentissage, le au moins un paramètre (OPT) statistique optimisé à l'utilisation dans le test ultérieur, tout en donnant la donnée de sortie.
